# EUROPÄISCHE PATENTSCHRIFT

(11) **EP 2 340 287 B1**
(45) Veröffentlichungstag und Bekanntmachung des Hinweises auf die Patenterteilung: **08.10.2014**
(21) Anmeldenummer: 09748237.6
(22) Anmeldetag: 21.10.2009
(51) Int. Cl.: C09J 7/00, B81C 1/00, A44B 18/00

(54) **VERFAHREN ZUR HERSTELLUNG EINES FORMKÖRPERS MIT HIERARCHISCHER STRUKTUR**
METHOD FOR THE PRODUCTION OF AN ARTICLE WITH A HIERARCHICAL STRUCTURE
PROCEDE DE FABRICATION D'UN OBJET AVEC STRUCTURE HIERARCHIQUE

(30) Priorität: 29.10.2008 DE 102008053619
(43) Veröffentlichungstag der Anmeldung: 06.07.2011
(73) Patentinhaber: Karlsruher Institut für Technologie, 76131 Karlsruhe (DE)
(72) Erfinder: WORGULL, Matthias, 76297 Stutensee (DE); HÖLSCHER, Hendrik, 76356 Weingarten (DE)
(86) Internationale Anmeldenummer: PCT/EP2009/007528
(87) Internationale Veröffentlichungsnummer: WO 2010/049081

(56) Entgegenhaltungen:
- WO-A1-2004/105536
- WO-A1-2005/087033
- WO-A2-2008/076391
- US-A- 4 070 515
- US-A1- 2005 148 984
- JEONG, H. E.: "Stretched Polymer Nanohairs by Nanodrawing" NANO LETTERS, Bd. 6, Nr. 7, 27. Juni 2006 (2006-06-27), Seiten 1508-1513, XP002580870 Washington, DC, American Chemical Society ISSN: 1530-6992 DOI: 10.1021/nl061045m

## Beschreibung

Die Erfindung betrifft ein Verfahren zur Herstellung eines Formkörpers.

Die physikalische Ursache, wieso Geckos auf senkrechten Wänden und sogar an Decken laufen können, wurde in den letzten Jahren sehr intensiv untersucht, siehe K. Autumn, How Geckos Toes Stick, American Scientist 94, S. 124, 2006. Inzwischen ist bekannt, dass die Zehen von Geckos aus kleinen, sehr feinen Härchen, den sog. *Setae,* die aufgrund der van-der-Waals Kräfte auf jeder beliebigen Oberfläche haften, bestehen. Damit ein mehrere hundert Gramm schwerer Gecko an der Decke haften kann, sind die Setae weiterhin in eine Vielzahl von nanostrukturierten Härchen, die als *Spatulae* bezeichnet werden, aufgespalten, siehe E. Arzt, S. Gorb und R. Spolenak, From micro to nano contacts in biological attachement devices, PNAS 100, S. 10603, 2003.

Wie in S. Gorb et al., Insects did it first: A micropatterned adhesive tape for robotic applications, Bioinsp. Biomim. 2, S. 117-125, 2007 beschrieben, wird versucht, derartige Strukturen technisch zu imitieren, um nun auf diese Weise ein ideales Klebeband herzustellen, das nahezu ideale Klebeeigenschaften hätte: - Es klebt auf (nahezu) jeder Oberfläche.
- Es lässt sich beliebig oft wieder verwenden.
- Die Klebewirkung wäre idealer Weise so groß, dass auch Menschen (oder zumindest Roboter) an Wänden und Decken laufen könnten.

Bisher wurden lithographische Techniken und Prägeverfahren eingesetzt, um derartige Strukturen herzustellen, siehe z. B. S. Reddy, E. Arzt und A. del Campo, Bioinspired Surfaces with Switchable Adhe sion, Adv. Mater. 19, S. 3833, 2007.

In A. del Campo et al., Patterned Surfaces with Pillars with Controlled 3D Tip Geometry Mimicking Bioattachment Devices, Adv. Mater. 19, S. 1973, 2007, wurden die Oberflächen von ca. 20 Mikrometer dicken Säulen entsprechend modifiziert.

L. Qu, L. Dai, M. Stone, Zh. Xia, Zh. Lin Wang, Carbon Nanotube Arrays with Strong Shear Binding-On and Easy Normal Lifting-Off, Science 322, S. 238, 2008, brachten eine Vielzahl von Kohlenstoff-Nanoröhren auf ein Substrat auf.

L. Ge, S. Sethi, L. Ci, P.M. Ajayan und A. Dhinojwala, Carbon nanotube-based synthetic gecko tapes, PNAS 104, S. 10792-95, 2007, setzen einzelne Nanoröhren als Spatulae auf synthetische Setae im Mikrometer-Maßstab aus Bündeln von Nanoröhren.

Die mit diesen Verfahren hergestellten Strukturen besitzen noch nicht auf Dauer die gewünschte Klebestärke, da die hierarchische Struktur der *Setae* und *Spatulae* bisher nicht ausreichend nachempfunden wurde.

Ausgehend hiervon ist es die Aufgabe der vorliegenden Erfindung ein Verfahren zu seiner Herstellung vorzuschlagen, das die vorher genannten Nachteile und Einschränkungen nicht aufweist.

Mit dem Verfahren soll ein Formkörper bereitgestellt werden, der die Struktur der *Setae* und Spatulae ausreichend nachempfindet, um auf Dauer eine möglichst hohe Klebestärke zu erzielen.

Weiterhin soll ein Verfahren zur Herstellung eines derartigen Formkörpers bereitgestellt werden, mit sich dem auf möglichst einfache Weise eine auf Dauer gut haftende Struktur herstellen lässt.

Diese Aufgabe wird durch die Merkmale der Ansprüche 1 oder 2 gelöst. Die Unteransprüche beschreiben jeweils vorteilhafte Ausgestaltungen der Erfindung.

Ein Formkörper besteht aus einem Substrat, auf das eine Vielzahl von ersten Fäden aufgebracht ist, die jeweils mit ihrer Unterseite fest mit der Oberfläche des Substrats verbunden sind. Diese Vielzahl von ersten Fäden entspricht der ersten Hierarchieebene der Gecko-Zehe, den Setae.

Weiterhin besitzt ein Formkörper eine Vielzahl von zweiten Fäden, deren Unterseiten jeweils fest mit der Oberfläche jedes ersten Fadens verbunden sind. Diese Vielzahl von zweiten Fäden entspricht der zweiten Hierarchieebene der Gecko-Zehe, den Spatulae.

Es sind sowohl die seitlichen Flächen (Flanken) der ersten Fäden als auch die seitlichen Flächen (Flanken) der zweiten Fäden in Form einer konkaven Fläche ausgestaltet. Sie verjüngen sich daher jeweils von ihrer Unterseite aus in Richtung ihrer Oberflächen, bevor sie jeweils in einen besonders ausgebildeten Kopf, der vorzugsweise eine ebene Oberfläche aufweist, übergehen. Damit sind die Flanken sämtlicher Fäden des erfindungsgemäßen Formkörpers nach innen gewölbt. Diese besondere Gestaltung der beiden Arten von Fäden ermöglicht eine besonders gute Haftung des Formkörpers an einer Oberfläche.

Die ersten Fäden besitzen eine Länge von 10 µm bis 1000 µm und eine Dicke von 1 µm bis 100 µm, wobei die Dicke der ersten Fäden stets geringer ist als ihre Länge.

Die zweiten Fäden besitzen eine Länge von 10 µm bis 1000 µm und eine Dicke von 0,1 µm bis 10 µm, wobei die Dicke der zweiten Fäden stets geringer ist als die Dicke der ersten Fäden.

Ein Formkörper besteht vorzugsweise aus einem verfestigten oder ausgehärteten Kunststoff.

Ein Formkörper lässt sich mit dem folgenden Verfahren herstellen.

Gemäß Schritt a) wird eine Schicht eines verfestigbaren oder aushärtbaren Kunststoffs zwischen zwei parallele, wärmeleitfähige Platten (Werkzeuge) eingebracht und hieran ein Pressdruck zwischen die beiden Platten angelegt. Dann werden die beiden Platten derart aufgeheizt, dass sich die Schicht auf eine Temperatur oberhalb des Glaspunkts des eingesetzten Kunststoffs erwärmt. Wichtig ist, dass sich die beiden Platten dadurch unterscheiden, dass sie auf ihrer Oberfläche eine unterschiedliche Adhäsionskraft oder Rauhigkeit aufweisen oder sie auf zwei verschiedene Temperaturen erhitzt werden.

Dann werden gemäß Schritt b) die beiden Platten auseinander gezogen, während die Temperatur oberhalb des Glaspunkts des eingesetzten Kunststoffs gehalten wird. Dadurch bleibt die Schicht an einer der beiden Platten haften, während sich an der anderen der beiden Platten aus der Schicht eine Vielzahl von ersten Fäden ausbildet.

Anschließend wird gemäß Schritt c) der Kunststoff vorzugsweise mittels Abkühlen verfestigt oder mittels Bestrahlung mit ultravioletter Strahlung ausgehärtet. Dadurch bildet sich ein Substrat, auf das eine Vielzahl von ersten Fäden aufgebracht ist, die jeweils mit ihrer Unterseite fest mit der Oberfläche des Substrats verbunden und deren Flanken eine konkave Fläche aufweisen, aus.

Im sich hierzu anschließenden Schritt d) wird das derart modifizierte Substrats, auf das eine Vielzahl von ersten Fäden aufgebracht ist, erneut zwischen zwei parallele, wärmeleitfähige Platten eingelegt und hieran eine Pressdruck angelegt. Dann werden die beiden Platten derart aufgeheizt, dass nun das modifizierte Substrat auf eine Temperatur oberhalb des Glaspunkts des Kunststoffs erwärmt wird.

Danach werden gemäß Schritt e) die beiden Platten auseinander gezogen, während die Temperatur oberhalb des Glaspunkts des eingesetzten Kunststoffs beibehalten wird. Dadurch bleibt das Substrat erneut an einer der beiden Platten haften, während an der anderen der beiden Platten eine Vielzahl von zweiten Fäden, deren Unterseiten jeweils fest mit der Oberfläche jedes ersten Fadens verbunden und deren Flanken jeweils eine konkave Fläche ausweisen, entsteht.

Dann wird gemäß Schritt f) der Kunststoff vorzugsweise mittels Abkühlen verfestigt oder mittels Bestrahlung mit ultravioletter Strahlung ausgehärtet, wodurch schließlich der erfindungsgemäße Formkörper erhalten wird.

Ein Formkörper lässt sich in einer alternativen Ausgestaltung mit dem folgenden Verfahren herstellen.

Gemäß Schritt a') wird eine Schicht eines verfestigbaren oder aushärtbaren Kunststoffs zwischen zwei parallele, wärmeleitfähige Platten (Werkzeuge) eingebracht und hieran ein Pressdruck zwischen die beiden Platten angelegt. Dann werden die beiden Platten derart aufgeheizt, dass sich die Schicht auf eine Temperatur oberhalb des Glaspunkts des eingesetzten Kunststoffs erwärmt. Der Unterschied zur obigen Verfahrensvariante besteht darin, dass hier die erste Platte eine flache Oberfläche aufweist, während die zweite Platte mit einer Struktur, deren Abstände den Dicken und deren Höhen den Längen der zu bildenden ersten Fäden entsprechen, versehen ist. Dadurch wird die Struktur der zweiten Platte derart in die Schicht hinein abgeformt, dass hieraus ein Substrat, auf das eine Vielzahl von ersten Fäden aufgebracht ist, die jeweils mit ihrer Unterseite fest mit der Oberfläche des Substrats verbunden sind und deren Flanken konkave Flächen darstellen, entsteht.

Danach werden gemäß Schritt e') die beiden Platten auseinander gezogen, während die Temperatur oberhalb des Glaspunkts des eingesetzten Kunststoffs beibehalten wird. Dadurch bleibt das Substrat an der ersten der beiden Platten haften, während an der zweiten der beiden Platten eine Vielzahl von zweiten Fäden, deren Unterseiten jeweils fest mit der Oberfläche jedes ersten Fadens verbunden und deren Flanken jeweils eine konkave Fläche ausweisen, entsteht.

Dann wird auch hier gemäß Schritt f) der Kunststoff vorzugsweise mittels Abkühlen verfestigt oder mittels Bestrahlung mit ultravioletter Strahlung ausgehärtet, wodurch endlich der erfindungsgemäße Formkörper erhalten wird.

Ein Formkörper lässt sich verwenden als Haftvorrichtung. Hierzu gehören insbesondere Klebebänder oder Pflaster, o-der Oberfläche von Teilen eines Roboters.

Die Erfindung weist insbesondere die im Folgenden erwähnten Vorteile auf. Die Strukturen sind feiner als das Werkzeug (Stempel). Derart hergestellte Strukturen ähneln denen von Gecko-Zehen mehr als die üblichen Strukturen.

Durch die konkave Struktur der Fäden sind die Setae und die Spatulae wesentlich elastischer und weicher als die üblicherweise eingesetzten Zylinder, die gerade Flanken aufweisen. Bei den erfindungsgemäßen Strukturen lässt sich das Verhältnis von Oberfläche und Elastizität wesentlich besser an die Erfordernisse eines idealen Klebebands anpassen als mit den üblichen Strukturen.

Die hierarchische Struktur lässt die Setae wesentlich besser an die Oberfläche anpassen als die aus dem Stand der Technik bekannten einfach geformten Strukturen.

Die Erfindung wird im Folgenden anhand eines Ausführungsbeispiels und den Figuren näher erläutert. Es zeigen:
- **Fig. 1**: Schematische Darstellung eines erfindungsgemäßen Formkörpers
- **Fig. 2**: Schematische Darstellung eines Verfahrens zur Herstellung eines erfindungsgemäßen Formkörpers
- **Fig. 3**: Schematische Darstellung eines alternativen Verfahrens zur Herstellung eines erfindungsgemäßen Formkörpers

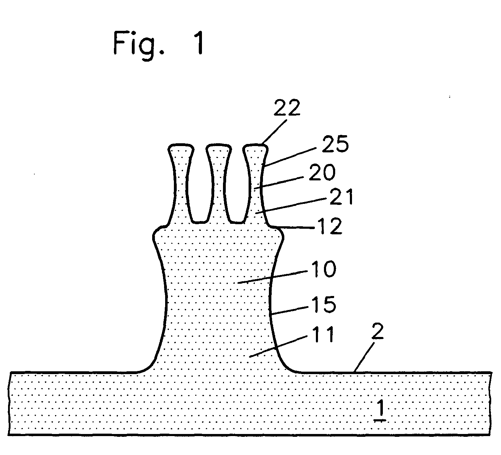

In Fig. 1 ist der Aufbau eines Formkörpers schematisch dargestellt. Ein derartiger Formkörper besteht aus einem Substrat 1, auf das eine Vielzahl von ersten Fäden 10 aufgebracht ist, die jeweils mit ihrer Unterseite 11 fest mit der Oberfläche 2 des Substrats 1 verbunden sind. Auf der der Oberfläche 12 eines jeden ersten Fadens 10 befinden sich eine Vielzahl von zweiten Fäden 20, deren Unterseiten 21 jeweils fest mit der Oberfläche 12 des betreffenden ersten Fadens 10 verbunden sind. Die Flanken 15 der ersten Fäden 10 und die Flanken 25 der zweiten Fäden 20 sind so ausgestaltet, dass sie sich jeweils von ihrer Unterseite 11 aus in Richtung ihrer Oberflächen 12 verjüngen, bevor sie jeweils in einen besonders ausgebildeten Kopf, der vorzugsweise eine ebene Oberfläche 12 besitzt, übergehen.

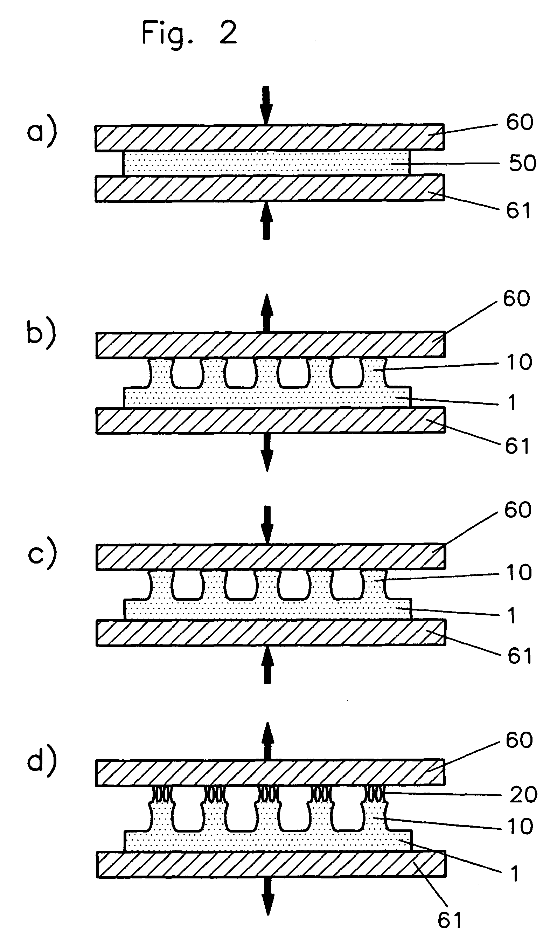

Fig. 2 zeigt eine schematische Darstellung eines Verfahrens zur Herstellung eines Formkörpers. Hierzu wird zunächst gemäß Fig. 2a) eine Schicht 50 eines Thermoplasts zwischen zwei parallele, wärmeleitfähige Platten 60, 61 eingebracht und ein Pressdruck zwischen die beiden Platten 60, 61 angelegt. Dann werden die beiden Platten 60, 61 auf zwei unterschiedliche Temperaturen so aufgeheizt, dass sich die Schicht 50 auf eine Temperatur oberhalb des Glaspunkts des Thermoplasts erwärmt.

Dann werden gemäß Fig. 2b) die beiden Platten 60, 61 auseinander gezogen, während die Temperatur oberhalb des Glaspunkts des Kunststoffs gehalten wird. Dadurch bleibt die Schicht 50 an einer Platte haften, während sich an der anderen Platte eine Vielzahl von ersten Fäden 10 ausbildet. Anschließend wird das Thermoplast abgekühlt und verfestigt. Dadurch entsteht ein Substrat 1 mit einer Vielzahl von ersten Fäden 10, die mit ihrer Unterseite fest 11 mit der Oberfläche des Substrats 2 verbunden sind und konkav geformte Flanken 15 aufweisen.

Dann wird gemäß **Fig. 2c****)** wird die modifizierte Schicht erneut zwischen die zwei parallelen, wärmeleitfähigen Platten **60, 61** eingelegt, hieran ein Pressdruck angelegt und die beiden Platten **60, 61** so aufgeheizt, dass die modifizierte Schicht erneut auf eine Temperatur oberhalb des Glaspunkts des Thermoplasts erwärmt wird.

Danach werden gemäß **Fig. 2d****)** die beiden Platten auseinander gezogen, während die Temperatur oberhalb des Glaspunkts des Kunststoffs beibehalten wird. Dadurch bleibt das Substrat **1** erneut an einer Platte haften, während sich an der anderen Platte eine Vielzahl von zweiten Fäden bildet. Schließlich wird das Thermoplast durch Abkühlen verfestigt und so der Formkörper erhalten.

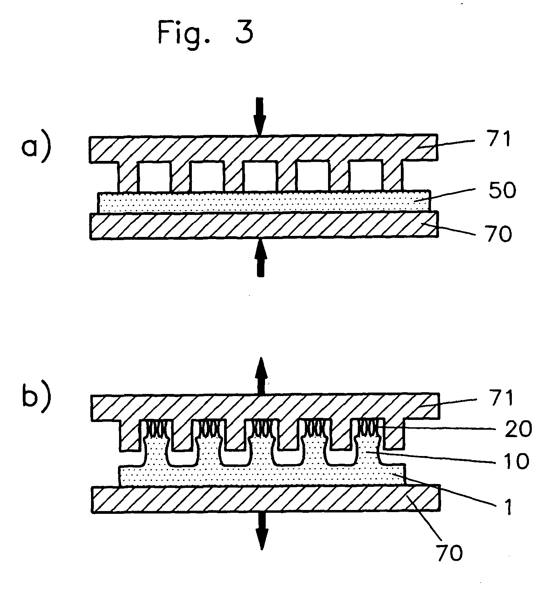

In **Fig. 3** ist ein alternatives Verfahren zur Herstellung eines Formkörpers schematisch dargestellt. Hierzu wird gemäß **Fig. 3 a)** eine Schicht **50** eines Thermoplasts zwischen zwei parallele, wärmeleitfähige Platten **70, 71** eingebracht und ein Pressdruck zwischen die beiden Platten **70, 71** angelegt. Dann werden die beiden Platten so aufgeheizt, dass sich die Schicht **50** auf eine Temperatur oberhalb des Glaspunkts des Thermoplasts erwärmt. Im Unterschied zu **Fig. 2** besitzt hier die erste Platte **70** eine flache Oberfläche, während die zweite Platte **71** eine Struktur, deren Abstände den Dicken und deren Höhen den Längen der zu bildenden ersten Fäden entsprechen, aufweist. Dadurch wird die Struktur der zweiten Platte **71** in die Schicht **50** so abgeformt, dass ein Substrat **1** mit einer Vielzahl von ersten Fäden **10,** die mit ihrer Unterseite fest **11** mit der Oberfläche des Substrats **2** verbunden sind und konkav geformte Flanken **15** aufweisen, entsteht.

Danach werden gemäß **Fig. 3b****)** die beiden Platten auseinander gezogen, während die Temperatur oberhalb des Glaspunkts des eingesetzten Thermoplasts beibehalten wird. Dadurch bleibt das Substrat **1** an der ersten Platte **70** haften, während sich an der zweiten Platte **71** eine Vielzahl von zweiten Fäden **20** bildet. Schließlich wird der Thermoplast durch Abkühlen verfestigt und so der Formkörper erhalten.

## Patentansprüche

1. Verfahren zur Herstellung eines Formkörpers, umfassend ein Substrat (1), auf das eine Vielzahl von ersten Fäden (10) aufgebracht ist, die jeweils mit ihrer Unterseite (11) fest mit der Oberfläche (2) des Substrats (1) verbunden sind, und eine Vielzahl von zweiten Fäden (20), deren Unterseiten (21) jeweils fest mit der Oberfläche (12) jedes ersten Fadens (10) verbunden sind, wobei die Flanken (15) der ersten Fäden (10) und die Flanken (25) der zweiten Fäden (20) konkav ausgestaltet sind, mit den **Verfahrensschritten**
a) Einbringen einer Schicht (50) eines verfestigbaren oder aushärtbaren Kunststoffs zwischen zwei parallele, wärmeleitfähige Platten (60, 61), Anlegen eines Pressdrucks zwischen die beiden Platten (60, 61) und Aufheizen der beiden Platten (60, 61), so dass die Schicht (50) auf eine Temperatur oberhalb des Glaspunkts des Kunststoffs erwärmt wird, wobei sich die beiden Platten (60, 61) dadurch unterscheiden, dass sie auf ihrer Oberfläche eine unterschiedliche Adhäsionskraft oder Rauhigkeit aufweisen oder sie auf zwei verschiedene Temperaturen erhitzt werden,
b) Auseinanderziehen der beiden Platten (60, 61) unter Beibehaltung der Temperatur oberhalb des Glaspunkts des Kunststoffs, wodurch die Schicht (50) an einer der beiden Platten haften bleibt, während sich an der anderen der beiden Platten aus der Schicht (50) eine Vielzahl von ersten Fäden (10) ausbildet,
c) Verfestigen oder Aushärten des Kunststoffs, wodurch ein Substrat (1), auf das eine Vielzahl von ersten Fäden (10), deren Länge von 5 µm bis 500 µm und deren Dicke von 1 µm bis 100 µm beträgt, aufgebracht ist, die jeweils mit ihrer Unterseite (11) fest mit der Oberfläche (2) des Substrats (1) verbunden und deren Flanken (15) konkav ausgestaltet sind, erhalten wird,
d) Einbringen des Substrats (1), auf das eine Vielzahl von ersten Fäden (10) aufgebracht ist, zwischen zwei parallele, wärmeleitfähige Platten (60, 61), Anlegen eines Pressdrucks zwischen die beiden Platten (60, 61) und Aufheizen der beiden Platten (60, 61), so dass das Substrat (1), auf das eine Vielzahl von ersten Fäden (10) aufgebracht ist, auf eine Temperatur oberhalb des Glaspunkts des Kunststoffs erwärmt wird,
e) Auseinanderziehen der beiden Platten (60, 61) unter Beibehaltung der Temperatur oberhalb des Glaspunkts des Kunststoffs, wodurch das Substrat (1) an einer der beiden Platten haften bleibt, während sich an der anderen der beiden Platten eine Vielzahl von zweiten Fäden (20), deren Unterseiten (21) jeweils fest mit der Oberfläche (12) jedes ersten Fadens (10) verbunden sind, deren Flanken (25) konkav ausgestaltet sind, deren Länge von 5 µm bis 500 µm beträgt und deren Dicke von 0,1 µm bis 10 µm, jedoch stets geringer ist als die Dicke der ersten Fäden (10), beträgt, ausbildet,
f) Verfestigen oder Aushärten des Kunststoffs, wodurch der Formkörper erhalten wird.

2. Verfahren zur Herstellung eines Formkörpers, umfassend ein Substrat (1), auf das eine Vielzahl von ersten Fäden (10) aufgebracht ist, die jeweils mit ihrer Unterseite (11) fest mit der Oberfläche (2) des Substrats (1) verbunden sind, und eine Vielzahl von zweiten Fäden (20), deren Unterseiten (21) jeweils fest mit der Oberfläche (12) jedes ersten Fadens (10) verbunden sind, wobei die Flanken (15) der ersten Fäden (10) und die Flanken (25) der zweiten Fäden (20) konkav ausgestaltet sind, mit den **Verfahrensschritten**
a') Einbringen einer Schicht (50) eines verfestigbaren oder aushärtbaren Kunststoffs zwischen zwei parallele, wärmeleitfähige Platten (70, 71), wobei die erste Platte (70) eine flache Oberfläche aufweist, während die zweite Platte (71) mit einer Struktur (72), deren Abstände den Dicken und deren Höhen den Längen der zu bildenden ersten Fäden (10) entsprechen, versehen ist,
Anlegen eines Pressdrucks zwischen die beiden Platten (70, 71) und Aufheizen der beiden Platten (70, 71), so dass die Schicht (50) auf eine Temperatur oberhalb des Glaspunkts des Kunststoffs erwärmt und in die Schicht (50) hinein die Struktur (72) derart abgeformt wird, dass sich hieraus ein Substrat (1), auf das eine Vielzahl von ersten Fäden (10), deren Länge von 5 µm bis 500 µm und deren Dicke von 1 µm bis 100 µm beträgt, aufgebracht ist, die jeweils mit ihrer Unterseite (11) fest mit der Oberfläche (2) des Substrats (1) verbunden und deren Flanken (15) konkav ausgestaltet sind, ausbildet,
e') Auseinanderziehen der beiden Platten (70, 71) unter Beibehaltung der Temperatur oberhalb des Glaspunkts des Kunststoffs, wodurch das Substrat (1) an der ersten Platte (70) haften bleibt, während sich an der zweiten Platte (71) eine Vielzahl von zweiten Fäden (20), deren Unterseiten (21) jeweils fest mit der Oberfläche (12) jedes ersten Fadens (10) verbunden sind, deren Flanken (25) konkav ausgestaltet sind, deren Länge von 5 µm bis 500 µm beträgt und deren Dicke von 0,1 µm bis 10 µm, jedoch stets geringer ist als die Dicke der ersten Fäden (10), beträgt ausbilden,
f) Verfestigen oder Aushärten des Kunststoffs, wodurch der Formkörper erhalten wird.

3. Verfahren nach Anspruch 1 oder 2, wobei der Kunststoff mittels Abkühlen verfestigt oder mittels Bestrahlung mit ultravioletter Strahlung ausgehärtet wird.

4. Verfahren nach einem der Ansprüche 1 bis 3, wobei die Oberflächen (12) der ersten Fäden (10) als ebene Flächen ausgestaltet werden.

5. Verfahren nach einem der Ansprüche 1 bis 4, wobei die Oberflächen (22) der zweiten Fäden (20) als ebene Flächen ausgestaltet werden.

## Claims

1. Method for the production of a moulded body, comprising a substrate (1) on which a plurality of first fibres (10) is applied, which are each firmly connected with their underside (11) to the surface (2) of the substrate (1), and a plurality of second fibres (20), the undersides (21) of which are each firmly connected to the surface (12) of each respective first fibre (10), wherein the flanks (15) of the first fibres (10) and the flanks (25) of the second fibres (20) are formed concave, comprising the steps of:
a) introducing a layer (50) of a settable or hardenable plastic between two parallel heat-conductive plates (60, 61), application of a compression pressure between the two plates (60, 61) and heating of the two plates (60, 61), so that the layer (50) is heated to a temperature above the glass transition point of the plastic, wherein the two plates (60, 61) differ in that on their surfaces they have a different adhesion power or roughness or they are heated to two different temperatures,
b) separating the two plates (60, 61) while keeping the temperature above the glass transition point of the plastic, whereby the layer (50) remains adhering to one of the two plates while on the other of the two plates, a plurality of first fibres (10) is formed from the layer (50),
c) setting or hardening the plastic, whereby a substrate (1) is obtained on which a plurality of first fibres (10) is applied which have a length from 5 µm to 500 µm and a thickness from 1 µm to 100 µm, which are each firmly connected with their underside (11) to the surface (2) of the substrate (1), and the flanks (15) of which are formed concave,
d) introducing the substrate (1), on which a plurality of first fibres is applied, between two parallel, heat-conductive plates (60, 61), application of a compression pressure between the two plates (60, 61) and heating of the two plates (60, 61), so that the substrate (1) on which a plurality of first fibres (10) is applied, is heated to a temperature above the glass transition point of the plastic,
e) separating the two plates (60, 61) while keeping the temperature above the glass transition point of the plastic, whereby the substrate (1) remains adhering to one of the two plates, while on the other of the two plates a plurality of second fibres (20) is formed, the undersides (21) of which are each firmly connected to the surface (12) of each respective first fibre (10), the flanks (25) of which are formed concave, the length of which is from 5 µm to 500 µm and the thickness from 0.1 µm to 10 µm but always less than the thickness of the first fibres (10),
f) setting or hardening the plastic, whereby the moulded body is obtained.

2. Method for the production of a moulded body, comprising a substrate (1) on which a plurality of first fibres (10) is applied, which are each firmly connected with their underside (11) to the surface (2) of the substrate (1), and a plurality of second fibres (20), the undersides (21) of which are each firmly connected to the surface (12) of each respective first fibre (10), wherein the flanks (15) of the first fibres (10) and the flanks (25) of the second fibres (20) are formed concave, comprising the method steps of:
a') introducing a layer (50) of a settable or hardenable plastic between two parallel heat-conductive plates (70, 71), wherein the first plate (70) has a flat surface while the second plate (71) is provided with a structure (72), the spacings of which correspond to the thickness and the heights of which correspond to the length of the first fibres (10) to be formed, application of a compression pressure between the two plates (70, 71) and heating of the two plates (70, 71), so that the layer (50) is heated to a temperature above the glass transition point of the plastic, and the structure (72) is deformed into the layer (50) such that from this a substrate (1) is obtained, on which is applied a plurality of first fibres (10), of which the length is from 5 µm to 500 µm and the thickness from 1 µm to 100 µm, which are each firmly connected with their underside (11) to the surface (2) of the substrate (1), and the flanks (15) of which are formed concave,
e') separating the two plates (60, 61) while keeping the temperature above the glass transition point of the plastic, whereby the substrate (1) remains adhering to the first plate (70) while on the second plate (71) a plurality of second fibres (20) is arranged, the undersides (21) of which are each firmly connected to the surface (12) of each respective first fibre (10), the flanks (25) of which are formed concave, the length of which is from 5 µm to 500 µm and the thickness from 0.1 µm to 10 µm but always less than the thickness of the first fibres (10),
f) setting or hardening the plastic, whereby the moulded body is obtained.

3. Method according to claim 1 or 2, wherein the plastic is set by cooling or hardened by means of irradiation with ultraviolet radiation.

4. Method according to any one of claims 1 to 3, wherein the surfaces (12) of the first fibres (10) are formed as flat faces.

5. Method according to any one claims 1 to 4, wherein the surfaces (22) of the second fibres (20) are formed as flat faces.

## Revendications

1. Procédé d'obtention d'un corps moulé comprenant un substrat (1) sur lequel est appliquée une série de premiers fils (10) qui sont respectivernent solidairement reliés à la face supérieure (2) du substrat (1) par leur côté inférieur (11) et une série de seconds fils (20) dont les côtés inférieurs (21) sont respectivement solidairement reliées à la face (12) de chacun des premiers fils (10), les flancs (15) des premiers fils (10) et les flancs (25) des seconds fils (20) étant concaves, procédé comprenant les étapes consistant à :
a) insérer une couche (50) d'un matériau synthétique solidifiable ou durcissable entre deux plaques parallèles thermiquement conductrices (60, 61), appliquer une pression de compression entre les deux plaques (60, 61) et chauffer ces deux plaques (60, 61) de façon à amener la couche (50) à une température supérieure à la température de transition vitreuse du matériau synthétique, les deux plaques (60, 61) se distinguant en ce qu'elles présentent sur leur surface une force d'adhérence ou une rugosité différente, ou étant chauffées à des températures différentes,
b) éloigner l'une de l'autre par traction les deux plaques (60, 61) en maintenant la température au-dessus de la température de transition vitreuse du matériau synthétique de sorte que la couche (50) continue à adhérer à l'une des deux plaques alors qu'elle forme sur l'autre plaque à partir de la couche (50) une série de premiers fils (10),
c) solidifier ou durcir le matériau synthétique de façon à obtenir un substrat (1) sur lequel est formée une série de premiers fils (10) dont la longueur est égale à 5 µm à 500 µm et dont l'épaisseur est égale à 1 à 100 µm, qui sont respectivement reliés solidairement par leur côté inférieur (11) à la face (2) du substrat et dont les flancs (15) sont concaves,
d) insérer le substrat (1) sur lequel est formée une série de premiers fils (10) entre deux plaques (60, 61) thermiquement conductrices, appliquer une pression de compression entre ces deux plaques (60, 61) et chauffer ces deux plaques (60, 61) de sorte que le substrat (1) sur lequel est formée une série de premiers fils (10) soit amenée à une température située au-dessus de la température de transition vitreuse du matériau synthétique,
e) éloigner l'une de l'autre par traction les deux plaques (60, 61) en maintenant la température au-dessus de la température de transition vitreuse du matériau synthétique de sorte que le substrat (1) continue à adhérer à l'une des deux plaques, tandis que se forme sur l'autre plaque, une série de seconds fils (20) dont les côtés inférieurs (21) sont respectivement solidairement reliés à la face (12) de chaque premier fil (10), dont les flancs (25) sont concaves, dont la longueur est égale à 5 µm à 500 µm et dont l'épaisseur est égale à 0,1 µm à 10 µm, mais toujours inférieure à l'épaisseur de premiers fils (10),
f) solidifier ou durcir le matériau synthétique de façon à obtenir le corps moulé.

2. Procédé d'obtention d'un corps moulé comprenant un substrat (1) sur lequel est appliquée une série de premiers fils (10) qui sont respectivement solidairement reliés par leur côté inférieur (11) à la face (2) du substrat (1), et une série de seconds fils (20) dont les côtés inférieurs (21) sont respectivement solidairement reliés à la face (12) de chacun des premiers fils, les flancs (15) des premiers fils (10) et les flancs (25) des seconds fils (20) étant concaves,
procédé comprenant les étapes consistant à :
a') insérer une couche (50) d'un matériau synthétique solidifiable ou durcissable entre deux plaques parallèles thermiquement conductrices (70, 71), la première plaque (70) comportant une face plane tandis que la seconde plaque (71) présente des éléments de structure (72) dont les distances correspondent aux épaisseurs et dont les hauteurs correspondent aux longueurs des premiers fils (10) à former,
appliquer une pression de compression entre les deux plaques (70, 71) et chauffer ces deux plaques (70, 71) de sorte que la couche (50) soit amenée à une température supérieure à la température de transition vitreuse du matériau synthétique, et, dans la couche (50), les éléments de structure (72) étant moulés de façon à obtenir un substrat (1) sur lequel est formée une série de premiers fils (10) dont la longueur est égale à 5 µm à 500 µm et dont l'épaisseur est égale à 1 µm à 100 µm, qui sont respectivement solidairement reliés par leur côté inférieur (11) à la surface (2) du substrat (1) et dont les flancs (15) sont concaves,
e') éloigner l'une de l'autre par traction, les deux plaques (70, 71) en maintenant la température au-dessus de la température de transition vitreuse du matériau synthétique de sorte que le substrat (1) continue à adhérer à la première plaque (70) alors qu'il se forme sur la seconde plaque (71) une série de seconds fils (20) dont les côtés inférieurs (21) sont respectivement solidairement reliés à la face (12) de chaque premiers fils (10), dont les flancs (25) sont concaves, dont la longueur est égale à 5 µm à 500 µm, et dont l'épaisseur est égale à 0,1µm à 100 µm, mais toutefois, toujours inférieures à l'épaisseur des premiers fils (10),
f) solidifier ou durcir le matériau synthétique de façon à obtenir le corps moulé.

3. Procédé conforme à la revendication 1 ou 2,
selon lequel le matériau synthétique est solidifié par refroidissement ou durci par irradiation avec un rayonnement ultraviolet.

4. Procédé conforme à l'une des revendications 1 à 3,
selon lequel les faces (12) des premiers fils (10) sont réalisées sous la forme de surfaces planes.

5. Procédé conforme à une des revendications 1 à 4,
selon lequel les faces (22) des seconds fils (20) sont réalisées sous la forme de surfaces planes.
